# NEUE EUROPÄISCHE PATENTSCHRIFT

(11) **EP 0 606 647 B2**
(45) Veröffentlichungstag und Bekanntmachung des Hinweises auf die Entscheidung über den Einspruch: **15.09.2004**
(45) Hinweis auf die Patenterteilung: 24.06.1998
(21) Anmeldenummer: 93121000.9
(22) Anmeldetag: 28.12.1993
(51) Int. Cl.: H03J 1/00, H04H 1/00

(54) **Verfahren zur Abstimmung eines mobilen Rundfunkempfängers**
Tuning method for a mobile radio receiver
Méthode d'accord pour un récepteur radio mobile

(30) Priorität: 15.01.1993 DE 4300875
(43) Veröffentlichungstag der Anmeldung: 20.07.1994
(73) Patentinhaber: BECKER GmbH, D-76307 Karlsbad (DE)
(72) Erfinder: Klos, Rainer, 76275 Ettlingen (DE)
(74) Vertreter: Westphal, Klaus, Dipl.-Ing.

(56) Entgegenhaltungen:
- EP-A- 0 189 622
- EP-A- 0 498 233
- US-A- 5 020 142
- ELECTRONICS WORLD AND WIRELESS WORLD, November 1991, SURREY GB Seiten 973 - 974 'RDS on the road'
- PATENT ABSTRACTS OF JAPAN vol. 13, no. 272 (E-777) 22. Juni 1989 & JP-A-01 062 923 (FUJITSU TEN LTD) 9. März 1989
- PATENT ABSTRACTS OF JAPAN vol. 15, no. 165 (E-1061) 25. April 1991 & JP-A-03 034 630 (SANYO ELECTRIC CO LTD) 14. Februar 1991
- PATENT ABSTRACTS OF JAPAN vol. 15, no. 86 (E-1039) 28. Februar 1991 & JP-A-02 301 330 (ALPINE ELECTRON INC) 13. Dezember 1990
- Fachzeitschrift Funk-Technik 34, Jahrgang Nr. 10/1979, Seiten T 475 und T 476
- Fachzeitschrift Funkschau 5/1982, Seiten 57 bis 60
- Bedienungsanleitung des Autoradios WKC 3851 RDS der Firma Grundig mit Druckvermerk auf Rückseite, "Grundig AG D-8510 Fürth 0/02 18151-941.02", Deckblatt, Rückseite, Seiten 2 bis 13

## Beschreibung

Die Erfindung betrifft ein Verfahren zur Abstimmung eines mobilen Rundfunkempfängers, insbesondere Autoradios, bei dem die empfangbaren Programme durch Sendersuchlauf einstellbar sind oder in einem Anzeigefeld symbolisch dargestellt und zur Auswahl mittels zugeordneter Tasten angeboten werden und bei dem mittels eines gesonderten Bedienelementes eine Fitterfunktion aktivierbar und deaktivierbar ist, mittels der Programme unterdrückbar und freigebbar sind. Ein derartiges Verfahren ist beispielsweise aus der Bedienungsanleitung des Autoradios WKC 3851 RDS der Firma Grundig bekannt.

Bei mobilen Rundfunkempfängern besteht der Bedarf, die am jeweiligen Standort empfangbaren Rundfunkprogramme zu erkennen, zu identifizieren und in überschaulicher Weise zur Auswahl anzubieten. Bei modernen Autoradios können alle empfangbaren Programme beispielsweise in alphabetischer Reihenfolge in einem Anzeigefeld zur Anzeige gebracht und mittels Tastendruck ausgewählt werden. Wegen der wachsenden Anzahl von empfangbaren Radiostationen, insbesondere in Ballungsgebieten, wird es aber zunehmend schwierig, die Darstellung im Anzeigefeld übersichtlich zu gestalten. In der Regel entspricht allerdings der größte Teil der an einem gegebenen Standort empfangbaren Rundfunkprogramme nicht dem persönlichen Geschmack des Hörers.

Aus der EP 0498 233 ist ein Rundfunkempfänger bekannt, mit dem der Benutzer eine Vorauswahl der empfangbaren Programme treffen kann. Dabei wird von den RDS(Radio-Daten-System)-Signalen der Rundfunkprogramme Gebrauch gemacht, die auch eine Programmart-Kennung (PTY = Program Type) beinhalten.

Danach werden die einzelnen Programme in bestimmte Klassen eingeteilt, wie z.B. Pop, Klassik oder Nachrichten. Der Benutzer hat mit dem Empfänger die Möglichkeit, im PTY-Modus bestimmte Programmarten auf Stationstasten abzuspeichern. Bei Betätigung einer solchen Taste gelangen dann nur Programme der entsprechenden Programmart zur Wiedergabe. Es zeigt sich jedoch, daß oft nicht alle Programme einer Programmart dem Geschmack des Hörers entsprechen bzw. er mitunter auch einige bestimmte Programme anderer Kategorien zur Auswahl haben möchte, die zudem vielleicht kein RDS-Signal aussenden.

Ausgehend vom vorbeschriebenen Stand der Technik wird deshalb mit der vorliegenden Erfindung angestrebt, die Anzahl der dargebotenen Rundfunkprogramme einzuschränken, indem die empfangbaren Programme nach Kriterien des Benutzers vom Gerät vorselektiert werden.

Diese Aufgabe wird durch die Merkmale der Ansprüche gelöst.

Am Empfänger wird mittels eines gesonderten Bedienalements eine Filterfunktion aktiviert und deaktiviert; bei aktivierter Filterfunktion werden erfindungsgemäß einzelne Programme aus dem Angebot selektiv unterdrückt, indem der Sendersuchlauf auf ihnen nicht mehr anhält oder indem sie im Anzeigefeld des Geräts gelöscht werden. Vorzugsweise erfolgt die Aktivierung und die Deaktivierung der Filterfunktion durch wiederholtes Betätigen desselben Bedienelements, da so nur ein Bedienelement für die Filterfunktion benötigt wird und Fehlbedienungen unwahrscheinlich werden.

Eine unter ergonomischen Gesichtspunkten vorteilhafte Ausführungsform des Verfahrens sieht vor, daß die Auswahl eines in dem Anzeigefeld zu unterdrückenden Programms durch Einstellen dieses Programms mittels der zugeordneten Taste bei aktivierter Filterfunktion und Betätigen des gesonderten Bedienelements mindestens während einer vorbestimmten Zeitspanne erfolgt. Analog erfolgt vorzugsweise die Unterdrückung eines Programms in dem Anzeigefeld durch Deaktivieren der Filterfunktion, Einstellen dieses Programms mittels der zugeordneten Taste und Betätigen des gesonderten Bedienelements mindestens während einer vorbestimmten Zeitspanne.

Wenn die Möglichkeit besteht, die Programm-Art einzelner Programme zu identifizieren, besteht gemäß einer Weiterbildung des Verfahrens die Möglichkeit, nicht nur einzelne Programme, sondern alle Programme einer bestimmten Programm-Art zu unterdrücken. Die Identifizierung der Programm-Art kann beispielsweise durch Auswertung der RDS-Daten erfolgen. Bei Unterdrückung eines bestimmten Programms werden dann zugleich auch alle anderen Programme unterdrückt, die von derselben, aus den RDS-Daten abgeleiteten Programm-Art sind.

Weitere Merkmale und Vorteile der Erfindung ergeben sich aus der folgenden Beschreibung und aus der Zeichnung, auf die Bezug genommen wird. In der Zeichnung zeigen:
Fig. 1 ein Blockschaltbild eines Autoradios zur Durchführung des erfindungsgemäßen Verfahrens; und
Fig. 2a, 2b und 2c ein Anzeigefeld des Autoradios in drei verschiedenen Zuständen.

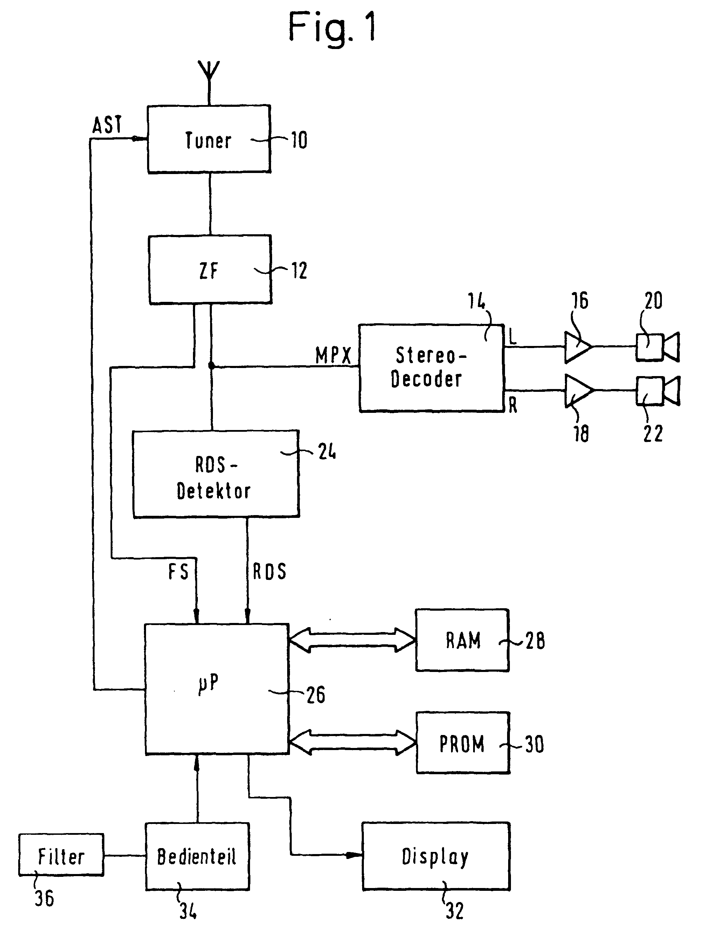

In herkömmlicher Weise enthält das in Fig. 1 dargestellte Autoradio einen Tuner 10, an den das Antennensignal angelegt ist, einen Zwischenfrequenzteil 12, einen Stereodecoder 14, an dessen Eingang das MPX-Signal vom Ausgang des Zwischenfrequenzteils 12 angelegt ist, und Verstärkerstufen 16, 18 zur Ansteuerung von Lautsprechern 20, 22. Das MPX-Signal ist ferner an den Eingang eines RDS-Detektors 24 angelegt.

Zur Steuerung des Autoradios ist ein Mikroprozessor 26 vorgesehen. Das Ausgangssignal RDS des RDS-Detektors 24 wird an den Mikroprozessor 26 angelegt. Der Mikroprozessor 26 gibt ein Abstimmsignal AST an den Tuner 10 aus. Durch einen Arbeitsspeicher 28 und einen programmierbaren Festwertspeicher 30 wird der Mikroprozessor 26 zu einem Mikrocomputer. Mit diesem Mikrocomputer verbunden sind ferner eine Anzeigeeinheit 32 und ein Bedienteil 34. An dieses Bedienteil ist ein Taster 36 angeschlossen, der die Beschriftung "Filter" trägt und mit einer Signallampe kombiniert ist.

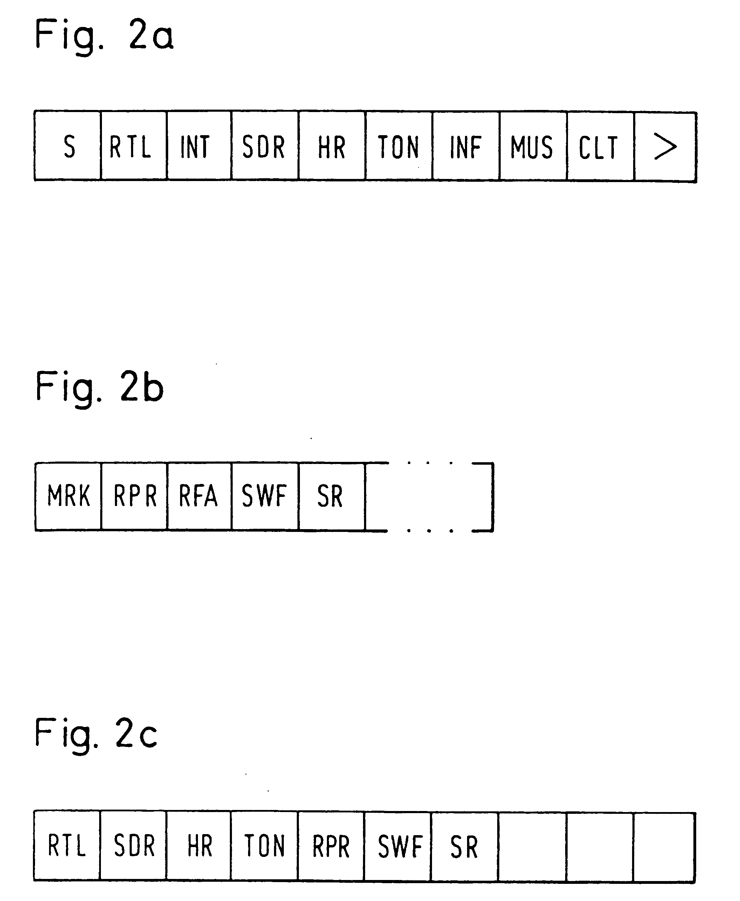

Nach dem Einschalten des Autoradios erscheint in dem Anzeigefeld 32 eine Zeile, in der die am aktuellen Standort empfangbaren Programme zur Auswahl angezeigt werden. Diese Zeile ist in Fig. 2a dargestellt. In den zehn aufeinanderfolgenden Feldern dieser Zeile werden neun Buchstaben-Kombinationen angezeigt, bei denen es sich um Abkürzungen der betreffenden Programm-Namen handelt. In dem zehnten Feld weist ein Zeichen darauf hin, daß weitere Programme, die in der einzigen Anzeige-Zeile keinen Platz mehr finden, verfügbar sind. Durch Betätigen eines zugeordneten Bedienelements werden die restlichen empfangbaren Programme in der Zeile zur Anzeige gebracht, wie in Fig. 2b dargestellt. Bei diesem Beispiel wird also davon ausgegangen, daß insgesamt vierzehn Programme zum Empfang verfügbar sind. Der Benutzer kann nun eines dieser Programme zum Empfang durchschalten. In der Praxis wird sich der Benutzer jedoch nur für einige der zur Verfügung stehenden Programme interessieren.

Gemäß dem erfindungsgemäßen Verfahren besteht nun die Möglichkeit, durch Betätigung eines gesonderten Bedienelements, nämlich des Tasters 36, eine Filterfunktion zu aktivieren. Bei erstmaliger Betätigung des Tasters 36 leuchtet der Schriftzug "Filter" auf, um die Aktivität der Filterfunktion zu signalisieren. Bei erneuter Betätigung des Tasters 36 wird die Filterfunktion deaktiviert; zugleich erlischt der Schriftzug "Filter".

Wenn nun der Benutzer bei aktivierter Filterfunktion eines der angebotenen Programme auswählt und anschließend den Taster 36 während einer Zeitspanne von mehr als 2 Sekunden betätigt, wird das betreffende Programm in der Anzeige-Zeile unterdrückt. Beispielshalber wird angenommen, daß der Benutzer sich im Raume Karlsruhe befindet und ursprünglich die in den Figuren 2a und 2b aufgeführten Programme empfangbar sind. Ferner soll angenommen werden, daß es sich um einen deutschsprachigen Benutzer handelt, der bevorzugt "POP-Musik" hört und sich nicht für französischsprachige Programme interessiert. Außerdem entsprechen die Programme S und MRK nicht seinem persönlichen Geschmack. Der Benutzer wird daher nach der oben beschriebenen Prozedur die folgenden Programme mittels der Filterfunktion unterdrücken: INT (Inter), INF (Info), MUS (Musique), CLT (Culture) und RFA (RF Alsac); ferner die Programme S (S2 Kultur, S4 ...) und MRK (Merkur).

Anschließend erscheinen in der Anzeige-Zeile der Anzeigeeinheit 32 nur noch sieben Programme, wie in Fig. 2c dargestellt. Dies sind nur noch Programme, für die sich der Benutzer interessiert. Sie können nunmehr in einer einzigen Zeile dargestellt werden.

Die Anzeige in der Anzeigeeinheit 32 wird ständig aktualisiert. Ändert also das Fahrzeug seinen Standort, werden nur noch die jeweils empfangbaren Programme angezeigt. Wenn neue Programme vom Gerät gefunden und identifiziert werden, werden diese in der Anzeigeeinheit 32 aufgenommen. Der Benutzer kann dann entscheiden, ob die neu angezeigten Programme seinem Geschmack entsprechen oder ob sie ausgefiltert werden sollen.

Bekanntlich ist in dem RDS-Datenstrom eine Information über die Programm-Art enthalten. Bei der bevorzugten Ausführungsform des Verfahrens wertet der Mikroprozessor 26 diese Information aus, um beim Auffinden eines neuen Programms nach einem Standortwechsel zu entscheiden, ob die Programm-Art des neu gefundenen Programms mit der Programm-Art eines durch die Filterfunktion unterdrückten Programms übereinstimmt. Wenn dies zutrifft, wird auch das neu gefundene Programm unterdrückt. Auf diese Weise entsteht im Laufe der Zeit eine Liste von nicht gewünschten Programmen, die in der Anzeigeeinheit 32 unterdrückt werden. Das Autoradio "lemt" also den Benutzergeschmack und richtet sich danach.

Bei deaktivierter Filterfunktion werden alle empfangbaren Programme in der Anzeigeeinheit 32 berücksichtigt.

Jedes mittels der Filterfunktion unterdrückte Programm kann nach Belieben wieder freigegeben werden. Zu diesem Zweck wird zunächst die Filterfunktion durch Betätigung des Tasters 36 deaktiviert. Das unterdrückte Programm wird wieder in der Anzeigeeinheit 32 angezeigt. Dieses Programm wird anschließend ausgewählt. Nun wird der Taster 36 während einer Zeitspanne von mehr als 2 Sekunden gedrückt. Schließlich wird der Taster 36 erneut betätigt, um die Filterfunktion wieder zu aktivieren. Das betreffende Programm ist nun freigegeben und wird in der Anzeigeeinheit 32 wieder berücksichtigt.

## Patentansprüche

1. Verfahren zur Abstimmung eines mobilen Rundfunkempfängers, bei dem die empfangbaren Programme zur Auswahl angeboten werden und bei dem mittels eines gesonderten Bedienelementes eine Filterfunktion aktivierbar und deaktivierbar ist, mittels der Programme unterdrückbar und freigebbar sind,
**dadurch gekennzeichnet, dass** unter den angebotenen Programmen einzelne Programme auswählbar sind und dass bei aktivierter Filterfunktion die ausgewählten Programme aus dem Angebot unterdrückt werden.

2. Verfahren nach Anspruch 1, bei welchem die empfangbaren Programme in einem Anzeigefeld (32) symbolisch dargestellt und zur Auswahl mittels zugeordneter Tasten angeboten werden, **dadurch gekennzeichnet, daß** bei aktivierter Filterfunktion einzelne Programme aus dem Angebot im Anzeigefeld (32) selektiv unterdrückt werden.

3. Verfahren nach Anspruch 1 oder 2, **dadurch gekennzeichnet, daß** die Aktivierung und die Deaktivierung der Filterfunktion durch wiederholtes Betätigen desselben Bedienelements (36) erfolgt.

4. Verfahren nach Anspruch 2 oder 3, **dadurch gekennzeichnet, daß** die Auswahl eines in dem Anzeigefeld zu unterdrückenden Programms durch Einstellen dieses Programms mittels der zugeordneten Taste bei aktivierter Filterfunktion und Betätigen des gesonderten Bedienelements (36) mindestens während einer vorbestimmten Zeitspanne erfolgt.

5. Verfahren nach einem der vorstehenden Ansprüche, **dadurch gekennzeichnet, daß** bei Unterdrükkung eines Programms zugleich auch alle anderen Programme unterdrückt werden, die von derselben, aus den RDS-Daten abgeleiteten Programm-Art sind.

## Claims

1. A method of tuning a mobile radio receiver wherein the available programs are offered for selection, wherein a program filter function is enabled or disabled by actuation of associated operating means and wherein programs are suppressed or released by the filter function, **characterized in that** particular programs are selectable from the offered programs and the selected programs are suppressed from the offer if said filter function is enabled.

2. The method according to claim 1, wherein the available programs are displayed in a display panel (32) with the aid of symbols and are offered for selection by means of associated keys, **characterized in that** when said fitter function is enabled, individual programs are selectively deleted from the offer in said display panel (32).

3. The method according to claim 1 or 2, **characterized in that** enabling and disabling said filter function is performed by renewed actuation of the same operating means (36).

4. The method according to claim 2 or 3, **characterized in that** the selection of a program to be deleted in the display panel is performed by setting said program by means of the associated key when said filter function is enabled, and actuating said operating means (36) at least during a predetermined period of time.

5. The method according to any one of the preceding claims, **characterized in that** when a program is deleted, all other programs which are of the same program type derived from the RDS data are also deleted.

## Revendications

1. Procédé pour accorder un récepteur mobile radio, dans lequel les programmes recevables sont offerts pour sélection et une fonction de filtrage à l'aide de laquelle des programmes peuvent être supprimés ou rendus accessibles est activable et désactivable au moyen d'un élément de commande particulier, **caractérisé en ce que**, parmi les programmes proposés, certains programmes peuvent être sélectionnés et, la fonction de filtrage étant activée, les programmes sélectionnés peuvent être supprimés de l'offre.

2. Procédé suivant la revendication 1, dans lequel les programmes recevables sont représentés symboliquement dans un champ d'affichage (32) et sont offerts pour sélection par l'intermédiaire de touches associées, **caractérisé en ce que**, lorsque la fonction de filtrage est activée, des programmes individuels sont supprimés sélectivement de l'offre dans le champ d'affichage (32).

3. Procédé suivant la revendication 1 ou 2, **caractérisé en ce que** l'activation et la désactivation de la fonction de filtrage sont effectuées par actionnement répété du même élément de commande (36).

4. Procédé suivant la revendication 2 ou 3, **caractérisé en ce que** la sélection d'un programme à supprimer du champ d'affichage, s'effectue par sélection de ce programme au moyen de la touche associée lorsque la fonction de filtrage est activée et par actionnement de l'élément de commande particulier (36) pendant au moins un laps de temps prédéterminé.

5. Procédé suivant l'une quelconque des revendications précédentes, **caractérisé en ce que**, lors de la suppression d'un programme, sont en même temps supprimés tous les autres programmes qui sont du même type de programme, dérivé à partir des données RDS.
